# DEMANDE DE BREVET EUROPEEN

(11) **EP 4 572 557 A1**
(43) Date de publication de la demande: **18.06.2025**
(21) Numéro de dépôt: 24219742.4
(22) Date de dépôt: 13.12.2024
(51) Int. Cl.: H10D 1/68

(54) **PROCEDE DE PREPARATION D'UN DISPOSITIF MULTICOUCHES FERROELECTRIQUE**

(30) Priorité: 15.12.2023 FR 2314317
(71) Demandeur: Commissariat à l'Energie Atomique et aux Energies Alternatives, 75015 Paris (FR)
(72) Inventeur: MALLMANN TONELLI, Amanda, 38054 GRENOBLE (FR); BEDJAOUI, Messaoud, 38054 GRENOBLE (FR); GRENOUILLET, Laurent, 38054 GRENOBLE (FR); JOUSSEAUME, Vincent, 38054 GRENOBLE (FR)
(74) Mandataire: Gevers & Orès

(57) **Abrégé**

La présente invention concerne un procédé de préparation d'un dispositif multicouches ferroélectrique, notamment ultrafin, comprenant une alternance d'au moins une couche d'un premier type et d'au moins une couche d'un deuxième type.

## Description

La présente invention concerne un procédé de préparation d'un dispositif multicouches ferroélectrique, notamment ultrafin, comprenant une alternance d'au moins une couche d'un premier type et d'au moins une couche d'un deuxième type.

Les mémoires ferroélectriques, bien que moins connues que leurs homologues non ferroélectriques, en particulier les mémoires magnétiques, suscitent un intérêt croissant dans le domaine de la technologie des mémoires, notamment des périphériques de stockage de masse.

Ces matériaux ferroélectriques, caractérisés par leur capacité à conserver une polarisation électrique rémanente, ont rapidement attiré l'attention des scientifiques et des ingénieurs en raison de leurs propriétés uniques. Leur utilisation dans les dispositifs mémoire offre en effet des avantages notables : ils sont non volatiles, ont des temps de lecture-écriture courts, utilisent des tensions compatibles avec l'électronique à base de silicium et consomment peu d'énergie.

Au cours des dernières années, la recherche sur les mémoires ferroélectriques a été limitée en raison de leur évolutivité dimensionnelle et de leur incompatibilité avec la technologie complémentaire métal-oxyde-semi-conducteur (CMOS). Néanmoins, depuis la découverte de la ferroélectricité dans des films de HfO₂ de 10 nm d'épaisseur en 2011, les mémoires ferroélectriques suscitent un intérêt croissant de la part des chercheurs et des fabricants de semi-conducteurs.

Plusieurs facteurs stabilisent la phase orthorhombique non centrosymétrique, qui serait à l'origine de ce comportement ferroélectrique de l'oxyde d'hafnium, tels que le budget thermique, la concentration en dopants et l'épaisseur du film.

Malgré les propriétés mentionnées plus haut, les matériaux à base d'HfO₂ présentent des défis cruciaux qui doivent être surmontés pour satisfaire aux exigences des mémoires ferroélectriques. Un défi consiste à réduire leur tension de fonctionnement tout en satisfaisant à l'exigence du budget thermique des procédés dits « Backend-of-the-line » (BEOL) de préparation des structures et des composants microélectroniques, dont les températures maximales admises sont inférieures à 450°C.

Cependant, lorsque le but est de développer des films ultrafins jusqu'à une épaisseur inférieure à l'épaisseur standard de 10 nm, en particulier pour des raisons de compacité, une augmentation de la température de recuit est à ce jour nécessaire pour obtenir la phase métastable ferroélectrique et maintenir les propriétés d'application, dépassant la limite autorisée de la technologie BEOL.

L'invention a pour but de permettre la mise en oeuvre d'une méthode de préparation d'un dispositif ferroélectrique qui évite les inconvénients précités.

Ainsi, un but de l'invention est de fournir une méthode de préparation d'un dispositif ferroélectrique, notamment ultrafin, tout en permettant la préservation d'un budget thermique compatible avec la technologie BEOL.

Un autre but de l'invention est de fournir une méthode de préparation permettant d'obtenir des dispositifs qui peuvent être destinés à des applications de mémoires ferroélectriques fonctionnant à des tensions très faibles.

Ainsi, selon un premier aspect, l'invention concerne un procédé de préparation d'un dispositif multicouches M ferroélectrique à n couches, n étant supérieur ou égal à 2, constitué de ou comprenant une alternance d'au moins une couche A et d'au moins une couche B,
ladite au moins une couche A étant, indépendamment, constituée de ou comprenant un composé choisi parmi les oxydes d'hafnium (HfO₂), les oxydes d'hafnium et de zirconium (HZO) enrichis en hafnium, les oxydes d'hafnium et de zirconium (HZO) dopés en aluminium, les oxydes d'hafnium et de zirconium (HZO) dopés en lanthane, les oxydes d'hafnium et de zirconium (HZO) dopés en gadolinium, les oxydes d'hafnium et de zirconium (HZO) dopés en yttrium, les oxydes d'hafnium et de zirconium (HZO) dopés en silicium, et les oxydes d'hafnium dopé en silicium (HSO),
ladite au moins une couche B étant, indépendamment, constituée de ou comprenant un composé choisi parmi les oxydes de zirconium (ZrO₂), les oxydes d'hafnium et de zirconium (HZO) enrichis en zirconium et les pérovskites,
ledit procédé comprenant les étapes suivantes :
   **(i)** une étape de préparation sur un substrat ou une électrode métallique inférieure d'un dispositif multicouches M' à n' couches, n' étant supérieur ou égal à 3, avec n' > n, comprenant une alternance desdites couches A et B, la première des n' couches, au contact de l'électrode métallique inférieure, étant une couche A,
   **(ii)** une étape de dépôt sur ledit dispositif multicouches M' obtenu à l'issue de l'étape (i), à l'opposé de ladite électrode métallique inférieure, d'une électrode métallique supérieure,
   **(iii)** une étape de recuit du dispositif obtenu à l'issue de l'étape (ii),
   **(iv)** une étape de retrait de l'électrode métallique supérieure du dispositif obtenu à l'issue de l'étape (iii),
   **(v)** une gravure sélective des n' - n couches supérieures, à l'opposé de l'électrode métallique inférieure, notamment totale, pour obtenir sur ladite l'électrode métallique inférieure le dispositif multicouches M,
   **(vi)** optionnellement, une étape de dépôt sur ledit dispositif multicouches M' obtenu à l'issue de l'étape (v), à l'opposé de ladite électrode métallique inférieure, d'une électrode métallique supérieure.

Selon un autre aspect, l'invention concerne un procédé de préparation d'un dispositif multicouches M ferroélectrique à n couches, n étant compris de 2 à 100, préférentiellement compris de 2 à 25, constitué de ou comprenant une alternance d'au moins une couche A et d'au moins une couche B,
ladite au moins une couche A étant, indépendamment, constituée de ou comprenant un composé choisi parmi les oxydes d'hafnium (HfO₂), les oxydes d'hafnium et de zirconium (HZO) enrichis en hafnium, les oxydes d'hafnium et de zirconium (HZO) dopés en aluminium, les oxydes d'hafnium et de zirconium (HZO) dopés en lanthane, les oxydes d'hafnium et de zirconium (HZO) dopés en gadolinium, les oxydes d'hafnium et de zirconium (HZO) dopés en yttrium, les oxydes d'hafnium et de zirconium (HZO) dopés en silicium, et les oxydes d'hafnium dopé en silicium (HSO),
ladite au moins une couche B étant, indépendamment, constituée de ou comprenant un composé choisi parmi les oxydes de zirconium (ZrO₂), les oxydes d'hafnium et de zirconium (HZO) enrichis en zirconium et les pérovskites,
ledit procédé comprenant les étapes suivantes :
   **(i)** une étape de préparation sur un substrat ou une électrode métallique inférieure d'un dispositif multicouches M' à n' couches, n' étant compris de de 3 à 101, avec n' > n, préférentiellement compris entre 3 et 26, comprenant une alternance desdites couches A et B, la première des n' couches, au contact de l'électrode métallique inférieure, étant une couche A,
   **(ii)** une étape de dépôt sur ledit dispositif multicouches M' obtenu à l'issue de l'étape (i), à l'opposé de ladite électrode métallique inférieure, d'une électrode métallique supérieure,
   **(iii)** une étape de recuit du dispositif obtenu à l'issue de l'étape (ii),
   **(iv)** une étape de retrait de l'électrode métallique supérieure du dispositif obtenu à l'issue de l'étape (iii),
   **(v)** une gravure sélective des n' - n couches supérieures, à l'opposé de l'électrode métallique inférieure, notamment totale, pour obtenir sur ladite l'électrode métallique inférieure le dispositif multicouches M,
   **(vi)** optionnellement, une étape de dépôt sur ledit dispositif multicouches M' obtenu à l'issue de l'étape (v), à l'opposé de ladite électrode métallique inférieure, d'une électrode métallique supérieure.

Selon un mode de réalisation particulier, ledit procédé comprend les étapes suivantes :
**(i)** une étape de préparation sur un substrat ou une électrode métallique inférieure d'un dispositif multicouches M' à n' couches, n' étant compris de 3 à 101, avec n' > n, préférentiellement compris entre 3 et 26, comprenant une alternance desdites couches A et B, la première des n' couches, au contact de l'électrode métallique inférieure, étant une couche A,
**(ii)** une étape de dépôt sur ledit dispositif multicouches M' obtenu à l'issue de l'étape (i), à l'opposé de ladite électrode métallique inférieure, d'une électrode métallique supérieure,
**(iii)** une étape de recuit du dispositif obtenu à l'issue de l'étape (ii),
**(iv)** une étape de retrait de l'électrode métallique supérieure du dispositif obtenu à l'issue de l'étape (iii),
**(v)** une gravure sélective des n' - n couches supérieures, à l'opposé de l'électrode métallique inférieure, notamment totale, pour obtenir sur ladite l'électrode métallique inférieure le dispositif multicouches M,
**(vi)** une étape de dépôt sur ledit dispositif multicouches M' obtenu à l'issue de l'étape (v), à l'opposé de ladite électrode métallique inférieure, d'une électrode métallique supérieure.

Par « oxydes d'hafnium et de zirconium (HZO) enrichis en zirconium », on entend en particulier les oxydes d'hafnium et de zirconium comprenant plus de 50%at (concentration atomique) de ZrO₂.

Parmi les pérovskites, on peut par exemple citer le zirconate de plomb (PbZrO₃), et l'hafniate de plomb (PbHfO₃).

Parmi les pérovskites, on peut par exemple citer le zirconate de plomb (PbZrO₃), l'hafniate de plomb (PbHfO₃), les pérovskites de type PZT/PZO pour Pb(Zr, Ti)Os, les titanates de baryum et de strontium (BST), et les pérovskites exemptes de plomb (par exemple LNO pour LiNbO₃, BFO pour BiFeO₃, NBT pour Na_{0.5}Bi_{0.5}TiO₃)

Par « oxydes d'hafnium et de zirconium (HZO) enrichis en hafnium », on entend en particulier les oxydes d'hafnium et de zirconium comprenant plus de 50%at, de préférence 1%at environ, de HfO₂.

Par « oxydes d'hafnium et de zirconium (HZO) dopés en aluminium », on entend en particulier les oxydes d'hafnium et de zirconium comprenant de 0,1% à 10%at, de préférence 1%at environ, de Al₂O₃.

Par « oxydes d'hafnium et de zirconium (HZO) dopés en lanthane », on entend en particulier les oxydes d'hafnium et de zirconium comprenant de 0,1% à 10%at, de préférence 1%at environ, de lanthane.

Par « oxydes d'hafnium et de zirconium (HZO) dopés en gadolinium », on entend en particulier les oxydes d'hafnium et de zirconium comprenant de 0,1% à 10%at, de préférence 1%at environ, de gadolinium.

Par « oxydes d'hafnium et de zirconium (HZO) dopés en yttrium », on entend en particulier les oxydes d'hafnium et de zirconium comprenant de 0,1% à 10%at, de préférence 1%at environ, d'yttrium.

Par « oxydes d'hafnium et de zirconium (HZO) dopés en silicium », on entend en particulier les oxydes d'hafnium et de zirconium comprenant de 0,1% à 10%at, de préférence 1%at environ, de SiO₂.

Par « oxydes d'hafnium dopé en silicium (HSO) », on entend en particulier les oxydes d'hafnium comprenant de 0,1% à 10%at, de préférence 1%at environ, de SiO₂.

Par « dispositif multicouches M ferroélectrique », on entend en particulier que le dispositif multicouche, est, lorsque considéré dans son ensemble, ferroélectrique. Le dispositif est ainsi globalement ferroélectrique, même si ce n'est pas nécessairement le cas de toutes les couches dudit dispositif.

De manière surprenante, il a d'ailleurs été mis en lumière que le dispositif multicouche M est ferroélectrique, et ce, malgré la présence de couches qui peuvent être non ferroélectriques, voire anti-ferroélectriques.

Et de façon tout aussi surprenante, la nature et la position des couches A et B telles que définies précédemment permet d' obtenir de façon certaine et bien définie un dispositif multicouche ferroélectrique.

Sans vouloir se restreindre à une quelconque théorie, les couches A, notamment la première, est susceptible de faciliter la formation d'un matériau ferroélectrique. Les couches A sont stables, même pour des épaisseurs inférieures à 10 nm.

Toujours sans vouloir se restreindre à une quelconque théorie, la ou les couches B sont susceptibles de favoriser la transition entre la phase tétragonale vers la phase orthorhombique, stabilisant ainsi la phase ferroélectrique.

Ceci est contre-intuitif car il pouvait être considéré que la ou les couches B cristallisent plus rapidement que les couches A, créant une contrainte de traction sur la couche supérieure, et entraînant une réduction de l'énergie d'activation pour transformer la phase tétragonale en phase monoclinique. Les phases monocliniques seraient devenues dominantes sur la phase orthorhombique dans l'échantillon, ce qui rend impossible la formation d'une structure ferroélectrique finale.

De plus, la ou les couches B sont susceptibles de permettre de réduire la température de recuit de la structure, car elles cristallisent à des plus basses températures. Et de façon critique, pour obtenir ledit dispositif M final sans passer par l'étape de gravure des couches supérieures (c'est-à-dire avec un recuit du nombre désiré de couches initiales), il serait nécessaire d'effectuer l'étape de recuit à environ 800°C, ce qui est incompatible avec les composants déjà présents sur le substrat. La réalisation d'un nombre supérieur de couches (empilement M') permet de faire un recuit à une température bien plus basse, par exemple à environ 400°C, ce qui est parfaitement compatible avec les composants déjà présents sur le substrat.

Ainsi, la structure, les propriétés et la nature même des couches du dispositif multicouches tel qu'obtenu à l'issue du procédé de l'invention diffèrent totalement de celle d'un empilement de couches (A/B)ₙ avec n ≥1, en particulier de par leur nature cristallographique. Et il en est de même du dispositif après gravure, par rapport à un ensemble de couches (A/B) initiales, diminué arbitrairement des couches correspondant à celles gravées.

Pour les raisons qui précèdent, la fonction (et donc l'intérêt) de la gravure sélective telle que définie dans le cadre de la présente invention est complètement différente de ce que pourrait être la simple gravure de monocouches A/B.

Par « ferroélectrique », on entend en particulier un dispositif qui possède une polarisation électrique à l'état spontané, polarisation qui peut être renversée par l'application d'un champ électrique extérieur, tel que par exemple mesuré par réponse en courant à la tension appliquée.

Par « une couche A (ou B) étant, indépendamment, constituée de ou comprenant... », on entend en particulier que les couches A peuvent être différentes les unes des autres, tout en étant toujours constituée de ou comprenant un composé choisi parmi le groupe défini précédemment. Selon un mode de réalisation particulier, les couches A (lorsqu'il y en a plus d'une) et/ou les couches B (lorsqu'il y en a plus d'une) sont constituées de ou comprennent un même composé tel que défini précédemment.

Ainsi, le dispositif M, après l'étape (iii) et après l'étape (vi), lorsque l'étape (vi) est réalisée, correspond à un dispositif MFM (pour « Métal Ferroelectric Métal »), dont la préparation consiste à déposer un matériau multicouche ferroélectrique, notamment par ALD, entre deux électrodes métalliques.

Selon un mode de réalisation particulier, n est compris de 2 à 25, notamment de 2 à 20, n étant par exemple de 2 ou 3, en particulier de 3.

Selon un mode de réalisation particulier, n'est compris de 3 à 26, notamment de 3 à 21, n' étant par exemple de 5.

Selon un mode de réalisation particulier, la dernière couche du dispositif multicouches M est une couche A.

Par « dernière couche du dispositif multicouches M », on entend en particulier la couche la plus éloignée du substrat ou de l'électrode métallique inférieure.

Selon un mode de réalisation particulier, le substrat est un substrat constitué de ou comprenant du silicium.

Selon un mode de réalisation particulier, le dispositif multicouche M' est préparé par dépôts successifs des couches A et B, en particulier par une technique de dépôt de couche atomique (ALD).

La technique de dépôt de couche atomique est susceptible de pouvoir développer des couches minces conformes, homogènes tout en en contrôlant l'épaisseur avec une précision inférieure au nanomètre.

Typiquement, le processus ALD commence par inonder la chambre de réaction avec un précurseur qui recouvre (ou « adsorbe ») la surface exposée du substrat. Ce processus est appelé autolimitatif car le précurseur ne peut s'adsorber que sur les zones exposées ; une fois que tous ceux-ci sont recouverts, l'adsorption s'arrête. Un deuxième gaz est ensuite introduit et réagit avec le précurseur pour former le matériau souhaité. Cette deuxième étape est également auto-limitée : une fois les sites précurseurs disponibles épuisés, la réaction s'arrête. Les deux étapes sont répétées jusqu'à obtenir l'épaisseur de film souhaitée. Le taux de croissance est généralement quantifié par la croissance par cycle (GPC : « growth per cycle »). Le cycle ALD typique se compose de deux demi-cycles, de doses séquentielles de précurseur et de co-réactif, qui sont séparées par des étapes de purge et de pompage, conduisant à une croissance de couche auto-limitée. Les co-réactifs et les oxydants sont généralement des sources d'oxygène (H₂O ou plasma d'oxygène). Pour obtenir le matériau multicouche, différentes monocouches ALD sont fabriquées, en alternant les pulses de précurseurs.

Selon un mode de réalisation particulier, les précurseurs des oxydes d'hafnium et de zirconium, lors des dépôts par une technique de dépôt de couche atomique, sont des précurseurs halogénés, en particulier HfCl₄ et ZrCl₄ respectivement.

Selon un autre mode de réalisation particulier, des précurseurs organométalliques, comme le TDMAZ (pour Tetrakis-dimethylamino-zirconium-IV) peuvent être utilisés.

Selon un autre mode de réalisation, le dispositif multicouche M' est préparé par dépôts successifs des couches A et B par d'autres techniques bien connues de l'homme du métier, en particulier par une technique de dépôt PVD (pour Physical Vapor Déposition, dépôt physique en phase vapeur), CVD (pour Chemical Vapor Déposition, dépôt chimique en phase vapeur) ou PLD (pour Pulsed Laser Déposition, ablation laser pulsé).

Selon un mode de réalisation particulier, les couches A et/ou B du dispositif multicouche M et/ou du dispositif multicouche M' ont une épaisseur comprise de 0,5 à 5 nm, notamment de 2 nm environ.

Selon un mode de réalisation particulier, les couches A ont une épaisseur comprise de 0,5nm à 5nm, préférentiellement de 2nm environ, et les couches B ont une épaisseur comprise de 0,5nm à 5nm, préférentiellement de 2nm environ.

Selon un mode de réalisation particulier, le dispositif multicouches M et/ou le dispositif multicouches M' ont une épaisseur inférieure à 50 nm, notamment inférieure à ou égale à 15 nm, en particulier inférieure à ou égale à 10 ou 6 nm.

Le retrait de l'étape (iv) est réalisable en utilisant les techniques de l'état de l'art comme la gravure ionique réactive au plasma à couplage inductif (ICP-RIE pour Inductively coupled plasma reactive ion etching), en utilisant par exemple une chimie à base de gaz halogéné (Cl₂, BCl₃, CHF₃) en association avec d'autres gaz (Ar, N₂, O₂, He).

D'autres techniques de retrait chimique peuvent être employées, par exemple pour retirer la couche en nitrure de titane, comme le mélange formé par les éléments chimiques d'hydroxyde d'ammoniac (NH₄OH), du peroxyde d'hydrogène H₂O₂ et de l'eau déionisée H₂O chauffé à 60°C.

La gravure de l'étape (v) permet de diminuer l'épaisseur de l'empilement total.

Sans vouloir se restreindre à une quelconque théorie, la gravure des couches A et B lors de l'étape (v) est sélective car elle exploite la différence d'orientation/structure desdites couches A et B. Cette sélectivité n'est au contraire pas obtenue pour un matériau ferroélectrique standard, uniforme et homogène, pour lequel les composants des couches A et B seraient mélangés.

Expérimentalement, et comme bien connu de l'homme du métier, les épaisseurs des structures peuvent être contrôlées en fonction du temps d'immersion ou de gravure et de la composition chimique des liquides utilisés.

Selon un mode de réalisation particulier, la gravure sélective de l'étape (v) est une gravure totale des n' - n couches supérieures, à l'opposé de l'électrode métallique inférieure.

Selon un autre mode de réalisation particulier, la gravure sélective de l'étape (v) est partielle (elle n'est donc pas totale). Dans ce cas, une partie ou l'intégralité des n' - n couches supérieures n'est que partiellement gravée et reste présente sur le dispositif M.

Selon un mode de réalisation particulier, la gravure sélective de l'étape (v) est une gravure humide ou sèche, notamment une gravure (ALE), par exemple par plasma (anisotrope), ou thermique (isotrope).

En général, et comme bien connu de l'homme du métier, il existe principalement deux classes de procédés de gravure: la gravure humide où le matériau est dissous lorsqu'il est immergé dans une solution chimique. Et la gravure sèche où le matériau est pulvérisé ou dissous à l'aide d'ions réactifs ou d'un agent de gravure en phase vapeur. Lorsque ledit matériau est dissous, et sans vouloir se restreindre à une quelconque théorie, il s'agit typiquement de la réaction du matériau avec des ions ou autres qui crée des espèces volatiles.

La vitesse à laquelle le processus de gravure se produit est appelée vitesse de gravure. Le processus de gravure est dit isotrope s'il se déroule dans toutes les directions à la même vitesse. S'il se déroule dans une seule direction et dépend fortement de la structure cristalline du matériau, alors il est anisotrope. Une considération importante dans tout processus de gravure est la « sélectivité » de l'agent de gravure. La sélectivité est obtenue lorsque deux matériaux différents ont des vitesses de gravure différentes dans les mêmes conditions ou lorsqu'un matériau grave tandis que l'autre ne grave pas. La sélectivité est mesurée comme le rapport entre les différentes vitesses de gravure de l'agent de gravure pour différents matériaux. La gravure anisotrope est possible grâce aux structures et aux orientations cristallines distinctes des différents matériaux qui composent la structure multicouche. L'exposition à différentes vitesses de gravure ou compositions chimiques est réalisée en fonction de la cristallinité du matériau.

A titre d'exemple, dans le cas d'une structure multicouche de HfO₂ et ZrO₂, une gravure de type « thermal atomic layer etching » (ALE) peut notamment être réalisée en utilisant des réactions de fluoration et d'échange de ligands. Le HF peut par exemple être utilisé pour la fluoration et Sn(acac)₂, AlCl(CH₃)₂ [chlorure de diméthylaluminium (DMAC)] ou TiCl₄ utilisés comme précurseurs métalliques pour l'échange de ligands. La méthode dite « Atomic layer etching » (ALE) est une méthode utilisée pour éliminer des films minces avec une précision de l'ordre de l'Angström à l'aide de réactions de surface séquentielles et auto-limitantes.

Selon un mode de réalisation particulier, l'invention concerne un procédé tel que décrit précédemment, dans lequel :
- La couche A du dispositif M' est à dominante amorphe ;
- La couche A du dispositif M est à dominante orthorhombique ;
- La couche B du dispositif M' est à dominante tétragonale ;
- La couche B du dispositif M est à dominante tétragonale.

Par « à dominante amorphe, orthorhombique ou tétragonale », on entend en particulier que la couche est à plus de 50% amorphe, orthorhombique ou tétragonale, respectivement.

Selon un mode de réalisation particulier, une partie de l'étape de recuit (iii) peut être confondue avec l'étape (ii). En effet, et à titre d'exemple, le budget thermique du procédé ALD (400°C pendant 15mn) typiquement nécessaire au dépôt d'une couche d'électrode supérieure en TiN de 10nm peut être suffisant à la cristallisation de la dernière couche A ou B, notamment A.

Le recuit peut être réalisé par toute technique bien connue de l'homme du métier, par exemple un recuit thermique rapide (RTA), ou un recuit à l'aide d'un four, d'une plaque chauffante, assisté par rayonnement, ou à l'aide d'un laser.

Selon un mode de réalisation particulier, le recuit de l'étape (iii) est réalisé à une température de 300 à 600 °C, notamment de 300 à 500°C, en particulier à 400°C environ.

Selon un mode de réalisation particulier, l'étape (vi) est réalisée.

Selon un mode de réalisation particulier, l'étape (vi) n'est pas suivie d'étape de recuit.

Selon un mode de réalisation particulier, lequel l'électrode métallique mentionnée relativement à l'étape (ii) et/ou l'électrode métallique mentionnée relativement à l'étape (vi) sont déposées par dépôt physique en phase vapeur (PVD) ou dépôt chimique en phase vapeur (CVD).

Selon un mode de réalisation particulier, l'électrode métallique inférieure mentionnée relativement à l'étape (i) est au contact, à l'opposé de la couche A, d'un substrat.

Selon un mode de réalisation particulier, le substrat est un substrat constitué de ou comprenant du silicium.

Selon un mode de réalisation particulier, l'électrode métallique mentionnée relativement à l'étape (i) est déposée par dépôt physique en phase vapeur (PVD) ou dépôt chimique en phase vapeur (CVD).

Selon un mode de réalisation particulier, l'électrode métallique mentionnée relativement à l'étape (i), l'électrode métallique mentionnée relativement à l'étape (ii) et/ou l'électrode métallique mentionnée relativement à l'étape (vi) sont constituées de ou comprennent un métal notamment choisi parmi titane, or, aluminium platine, ruthénium, molybdène, cuivre, et tungstène, un matériau comprenant ledit métal, notamment un nitrure métallique, par exemple TiN, WN, TaN, ou MoN, ou leurs mélanges.

Selon un mode de réalisation particulier, l'électrode métallique mentionnée relativement à l'étape (i), l'électrode métallique mentionnée relativement à l'étape (ii) et/ou l'électrode métallique mentionnée relativement à l'étape (vi) ont une épaisseur comprise de 2 ou 5 à 500nm, notamment de 2, 5 ou 10 à 100nm, en particulier de 2 ou 5 à 20nm.

Le substrat, ou lorsqu'il est absent, l'électrode métallique inférieure, peut être plan(e) ou non-plan(e). Etant donné que l'ensemble des couches décrites ci-dessus (la au moins une couche A, la au moins une couche B, et lorsqu'elles sont présentes, l'électrode métallique inférieure et/ou l'électrode métallique supérieure) a généralement une épaisseur constante (typiquement une épaisseur étant de ±10%, en particulier de ±1%, de sa valeur moyenne), l'ensemble des couches décrites ci-dessus a la même géométrie structurale que le substrat sur lequel cet ensemble repose, ou lorsqu'il est absent, que l'électrode métallique inférieure sur laquelle il repose.

Selon un autre aspect, la présente invention concerne également un procédé de préparation de structures tridimensionnelles comprenant au moins un dispositif M tel que décrit précédemment, notamment une pluralité de dispositifs M, lequel est préparé selon les étapes telles que décrites précédemment.

Le dispositif M selon l'invention peut être utilisé dans la préparation de capacitances MIM (Métal-Isolant-Métal) ferroélectriques, notamment dans un dispositif de mémoire.

### Définitions

Tel qu'on l'entend ici, les plages de valeur sous forme de « x-y » ou « de x à y » ou « entre x et y » incluent les bornes x et y, les entiers compris entre ces bornes, ainsi que tous les autres nombres réels compris entre ces bornes. A titre d'exemple, « 1-5 », ou « de 1 à 5 » ou « entre 1 et 5 » désignent les entiers 1, 2, 3, 4 et 5, ainsi que tous les autres nombres réels compris entre 1 et 5. Les modes de réalisations préférés incluent chaque entier pris individuellement dans la plage de valeur, ainsi que toute sous-combinaison de ces entiers et tout ensemble de nombres réels compris entre ces entiers. A titre d'exemple, les valeurs préférées pour « 1-5 » peuvent comprendre les entiers 1, 2, 3, 4, 5, 1-2, 1-3, 1-4, 1-5, 2-3, 2-4, 2-5, etc.

Tel qu'on l'utilise dans la présente description, le terme « environ » se réfère à un intervalle de valeurs de ± 10 % d'une valeur spécifique. A titre d'exemple, l'expression « environ 20 » comprend les valeurs de 20 ± 10 %, soit les valeurs de 18 à 22.

Par couche, on entend notamment une strate d'éléments superposés. Cette strate fait généralement référence à une couche dont les propriétés physico-chimiques et structurales sont uniformes et homogènes, sur le plan et sur sa profondeur.

Par première couche, on entend notamment une couche en contact avec une deuxième couche et, optionnellement, avec un substrat.

Par deuxième couche, on entend notamment une couche en contact avec la première couche et avec, lorsqu'elle existe, la troisième couche.

Par troisième couche, on entend notamment une couche en contact avec la deuxième couche et avec, lorsqu'elle existe, la quatrième couche, et ainsi de suite.

### FIGURES

La **figure 1** illustre un dispositif obtenu selon un procédé selon l'invention tel que décrit à l'exemple 1, étape 1.
La **figure 2** illustre un dispositif obtenu selon un procédé selon l'invention tel que décrit à l'exemple 1, étape 2.
La **figure 3** illustre un dispositif obtenu selon un procédé selon l'invention tel que décrit à l'exemple 1, étape 3.

### EXEMPLES

### Exemple 1 : Préparation d'un dispositif selon un procédé de l'invention

### Etape 1 : Réalisation de l'empilement ferroélectrique

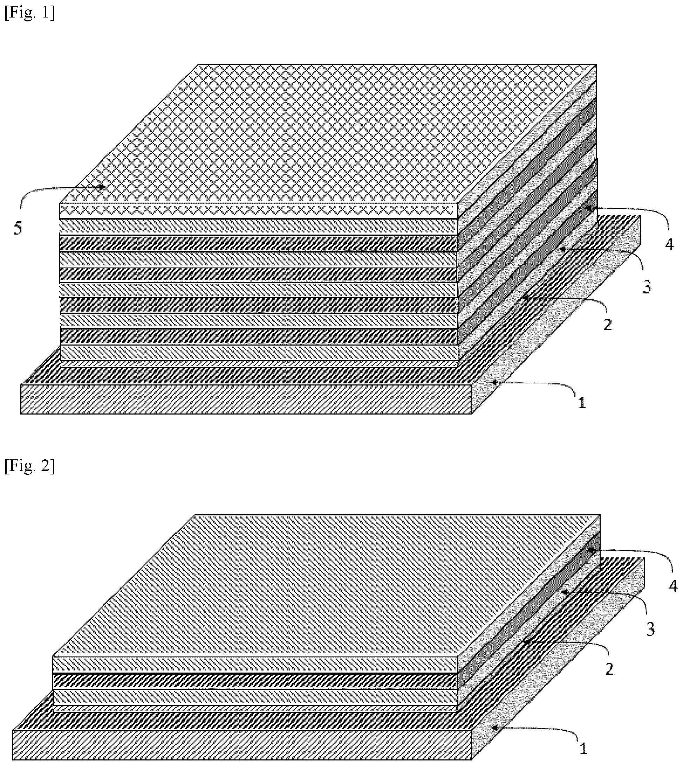

Cette étape a trait à la réalisation d'un empilement de couches A et B sur un substrat généralement en silicium (1) contenant une électrode inférieure métallique (2) (figure 1). D'une manière générale, la capacitance MFM (Métal Ferroelectric Métal) en tant que telle est réalisée par des techniques connues dans l'état de l'art antérieur. La figure 1 est une représentation schématique d'une vue de dessus d'une capacitance élémentaire disposée sur le substrat rigide. La configuration de la figure 1 est donnée à titre indicatif afin d'illustrer les principes de cette invention. L'empilement d'une capacitance élémentaire présenté dans la figure 1 est constitué d'électrodes inférieure (2) et supérieure (5) de nature métallique (par exemple titane, or, aluminium platine, tungstène ou tous autres métaux utilisés en tant que collecteur) disposées sur le substrat rigide (1). Les électrodes inférieure (2) et supérieure (5) sont de matériaux ayant une bonne conductivité électronique (exemple TiN, TaN, W, ...). Dans cet exemple ont été utilisées des électrodes en titane (TiN) d'une épaisseur de 15 nm pour l'électrode inférieure (2) et 50 nm pour l'électrode supérieure (5) obtenue à partir d'un dépôt sous vide (PVD pour Physical Vapor Déposition) ou CVD (Chemical vapor déposition). La structure multicouche diélectrique ferroélectrique est un isolant électronique. Dans cet exemple, il s'agit d'une couche de 2 nm d'épaisseur en HfO₂ (3) et 2 nm d'épaisseur en ZrO₂ (4) mais il peut être remplacé par d'autres matériaux tels que définis précédemment. Afin d'initier les réactions chimiques entre le précurseur injecté et la surface de l'échantillon, de l'énergie est nécessaire. Elle est fournie ici sous forme d'énergie thermique. Les températures typiques de ces réactions sont situées entre 150°C et 300°C et dépendent du type de précurseur utilisé. Les films fins ferroélectriques préparés par ALD thermique et en utilisant des précurseurs chlorés sont déposés à 300°C, par exemple. Dans un mode de réalisation, une couche de HfO₂ (3) est formée sur une électrode inférieure (2) montée dans une chambre de réaction en utilisant l'ALD dans une séquence répétitive comprenant le pulse d'un précurseur contenant de l'hafnium dans la chambre de réaction suivie par le pulse d'un gaz de purge, puis le pulse d'un premier précurseur contenant de l'oxygène dans la chambre. En utilisant l'ALD, une couche de HfO₂ est formée en utilisant du HfCl₄ comme précurseur contenant de l'hafnium, de la vapeur d'eau comme premier précurseur contenant de l'oxygène et de l'argon comme gaz de purge et gaz porteur. Après avoir formé la couche de HfO₂ (3), la couche de ZrO₂ (4) est formée sur la couche de HfO₂ (3). La couche de ZrO₂ (4) est formée par ALD. En particulier, une séquence répétitive comprend l'utilisation de ZrCl₄ comme précurseur contenant du zirconium avec une solution vapeur de H₂O comme précurseur contenant de l'oxygène, et de l'argon comme gaz de purge et gaz porteur. Le nanolaminé HfO₂/ZrO₂ comprend de multiples couches du composite HfO₂/ZrO₂, la couche initiale disposée sur une électrode inférieure (2) étant une couche de HfO₂. (3) Après cette couche initiale de HfO₂ (3), se trouvent des couches alternées de HfO₂ et de ZrO₂, chacun avec l'épaisseur de couche souhaitée, en appliquant le nombre approprié de cycles en fonction du GPC de chaque matériau. Et la couche de terminaison étant une couche de HfO₂ dans ce mode de réalisation. Après le procédé de dépôt ALD dans ces conditions, on obtient généralement un matériau amorphe. Le dépôt de l'électrode supérieure (5) est effectué et après intégration complète de la capacitance MFM, la structure est soumise à un recuit thermique à 400°C pendant 1h sous atmosphère d'azote, par exemple, obtenant ainsi un matériau cristallin avec la phase orthorhombique et les propriétés ferroélectriques. Chaque couche unitaire aura cependant une orientation cristalline différente comme le montre la figure 1.

Le terme « nanolaminé » désigne un film composite de couches ultra fines de deux matériaux ou plus dans un empilement de couches, où les couches sont des couches alternées de matériaux du film composite. Généralement, les nanolaminés ont des épaisseurs d'un ordre de grandeur de l'ordre du nanomètre. Chaque couche de matériau individuelle du nanolaminé peut avoir des épaisseurs aussi faibles qu'une monocouche de matériau. Un nanolaminé de HfO₂ et de ZrO₂ comprend au moins une fine couche de HfO₂ et une fine couche de ZrO₂, et est généralement écrit sous la forme d'un nanolaminé de HfO₂/ZrO₂.

### Etape 2 : Réalisation de la gravure sélective de la structure multicouche

C'est l'étape permettant de réduire l'épaisseur finale de la structure multicouche ferroélectrique après intégration complète de la capacitance MFM. Cette opération est réalisée par une gravure sélective, humide ou sèche, du matériau. La couche de l'électrode supérieure, nitrure de titane par exemple, est normalement gravée à l'aide d'une source gazeuse comprenant du chlore et un fluorocarbone. Après retrait de l'électrode supérieure, la structure multicouche devient accessible pour une gravure sélective, en raison des différentes phases et orientations cristallines des matériaux obtenus après recuit.

Conformément à un mode de réalisation de la présente invention, la gravure sélective de la structure est réalisée, en utilisant les vitesses de gravures respectives R1 et R2, pour les couches composées du matériau A et du matériau B, respectivement. Les vitesses de gravure peuvent être sélectionnées de manière appropriée sur la base de facteurs connus, tels que le temps, la température, le type d'acide, du fluorure et de l'oxyde à graver, et de la sélectivité obtenue pour le type spécifique les matériaux entourant l'oxyde à graver, et d'autres facteurs connus ou facilement déterminés. Comme indiqué, l'objectif de la présente invention est de graver des oxydes, par exemple des oxydes d'hafnium ou zirconium tels que ceux définis ci-dessus, de manière sélective par rapport aux matériaux qui entourent généralement ou existent dans des structures adjacentes ou proches, et qui pourraient être gravés par la même composition de gravure en l'absence d'une telle sélectivité. Ainsi, la composition de gravure doit présenter une vitesse de gravure élevée de ces oxydes, tout en présentant une vitesse de gravure relativement faible de ces matériaux qui ne sont pas destinés à être gravés, tels que les nitrures, les métaux, le silicium, et matériaux photorésistants (résines photosensibles).

À titre d'exemples, il peut être proposé une composition de gravure humide sélective de l'HfO₂ comprenant un acide fluorhydrique (HF). Comme le HfO₂ cristallin n'est pas gravé dans une solution de HF diluée à température ambiante, il est possible d'effectuer le retrait en contrôlant la vitesse de gravure en fonction de la température. Une vitesse de gravure d'environ 500 nm/min est obtenue dans une solution concentrée à 20 % de HF en chauffant la solution à 80°C. De plus, le HfO₂ amorphe peut être éliminé par HF en gravure HF humide à température ambiante. De plus, de bonnes propriétés des plasmas à base de Cl₂ et BCl₃ pour la gravure de ZrO₂ et HfO₂ peuvent être obtenues. D'une façon générale, les mêmes comportements sont observés pour HfO₂ et ZrO₂ avec cependant une vitesse de gravure plus élevée pour ZrO₂, favorisant une plus grande sélectivité. De plus, l'atomic layer etching (ALE) de HfO₂ et ZrO₂ peut être réalisée en utilisant des expositions séquentielles avec du fluorure d'hydrogène (HF) comme réactif de fluoration et du chlorure de diméthylaluminium (DMAC, AlCl(CH₃)₂) comme réactif métallique pour l'échange de ligands. Le DMAC pourrait fournir des ligands CH₃ ou Cl pour la réaction d'échange de ligands. La présence du ligand Cl sur le DMAC a conduit à une gravure efficace du HfO₂ et du ZrO₂ attribuée à la formation d'espèces de chlorure stables et volatiles. Les taux de gravure et les changements de masse au cours des réactions individuelles de HF et DMAC sont distincts pour les différentes couches de HfO₂ et de ZrO₂ et peuvent être réalisés par ALE thermique à différentes températures, conduisant ainsi à une gravure sélective de chaque couche. Les taux de gravure de 0,98 Å/cycle et 1,33 Å/cycle pour HfO₂ et ZrO₂, respectivement, à 200, 225, 250, 275 et 300°C peuvent être utilisés. L'opération de gravure des couches peut être répétée de nombreuses fois jusqu'à ce que l'épaisseur finale souhaitée de la structure soit atteinte comme dans la figure 2.

Il est en outre à noter que la profondeur des ablations et la quantité de couches gravées peuvent être obtenues par une variation du temps de l'attaque chimique ou par la concentration des réactifs utilisés, ainsi que par la vitesse de gravure et le nombre de fois que la séquence sera répétée.

### Etape 3 : Intégration du dispositif

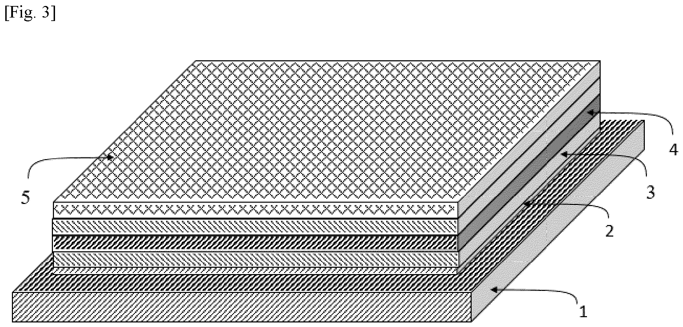

Après gravure sélective de la structure multicouche et réduction de l'épaisseur de la couche diélectrique ferroélectrique, la dernière étape technique concerne l'intégration de l'électrode supérieure et la non-nécessité de recuit. La figure 3 représente l'empilement formé par le substrat, la capacité MFM, avec ses électrodes inférieure (2) et supérieure (5) et son multicouche ferroélectrique ultra fin.

L'électrode métallique supérieure (5) est à nouveau déposée, titane, or, aluminium, platine, tungstène, par exemple, obtenue par dépôt PVD ou CVD (Chemical vapor déposition), et cette fois sans recuit ultérieur en conservant les spécificités de la technologie BEOL et les propriétés diélectriques ferroélectriques du matériau.

## Revendications

1. Procédé de préparation d'un dispositif multicouche M ferroélectrique à n couches, n étant compris de 2 à 100, préférentiellement compris de 2 à 25, constitué de ou comprenant une alternance d'au moins une couche A et d'au moins une couche B, ladite au moins une couche A étant, indépendamment, constituée de ou comprenant un composé choisi parmi les oxydes d'hafnium (HfO₂), les oxydes d'hafnium et de zirconium (HZO) enrichis en hafnium, les oxydes d'hafnium et de zirconium (HZO) dopés en aluminium, les oxydes d'hafnium et de zirconium (HZO) dopés en lanthane, les oxydes d'hafnium et de zirconium (HZO) dopés en gadolinium, les oxydes d'hafnium et de zirconium (HZO) dopés en yttrium, les oxydes d'hafnium et de zirconium (HZO) dopés en silicium, et les oxydes d'hafnium dopé en silicium (HSO),
ladite au moins une couche B étant, indépendamment, constituée de ou comprenant un composé choisi parmi les oxydes de zirconium (ZrO₂), les oxydes d'hafnium et de zirconium (HZO) enrichis en zirconium et les pérovskites,
ledit procédé comprenant les étapes suivantes :
**(i)** une étape de préparation sur un substrat ou une électrode métallique inférieure d'un dispositif multicouches M' à n' couches, n' étant compris de 3 à 101, avec n' > n, préférentiellement compris entre 3 et 26, avec n' > n, comprenant une alternance desdites couches A et B, la première des n' couches, au contact de l'électrode métallique inférieure (2), étant une couche A,
**(ii)** une étape de dépôt sur ledit dispositif multicouches M' obtenu à l'issue de l'étape (i), à l'opposé de ladite électrode métallique inférieure (2), d'une électrode métallique supérieure (5),
**(iii)** une étape de recuit du dispositif obtenu à l'issue de l'étape (ii),
**(iv)** une étape de retrait de l'électrode métallique supérieure (5) du dispositif obtenu à l'issue de l'étape (iii),
**(v)** une gravure sélective des n' - n couches supérieures, à l'opposé de l'électrode métallique inférieure (2), notamment totale, pour obtenir sur ladite l'électrode métallique inférieure (2) le dispositif multicouches M,
**(vi)** optionnellement, une étape de dépôt sur ledit dispositif multicouches M' obtenu à l'issue de l'étape (v), à l'opposé de ladite électrode métallique inférieure (2), d'une électrode métallique supérieure (5).

2. Procédé selon l'une quelconque des revendications précédentes, dans lequel la dernière couche du dispositif multicouches M est une couche A.

3. Procédé selon l'une quelconque des revendications précédentes, dans lequel le dispositif multicouches M' est préparé par dépôts successifs des couches A et B, en particulier par une technique de dépôt de couche atomique (ALD), dans laquelle les précurseurs des oxydes d'hafnium et de zirconium sont notamment des précurseurs halogénés, en particulier HfCl₄ et ZrCl₄ respectivement.

4. Procédé selon l'une quelconque des revendications précédentes, dans lequel les couches A et/ou B du dispositif multicouches M et/ou du dispositif multicouches M' ont une épaisseur comprise de 0,5 à 5 nm, notamment de 2 nm environ.

5. Procédé selon l'une quelconque des revendications précédentes, dans lequel les couches A ont une épaisseur comprise de 0,5nm à 5nm, préférentiellement de 2nm environ, et les couches B ont une épaisseur comprise de 0,5nm à 5nm, préférentiellement de 2nm environ.

6. Procédé selon l'une quelconque des revendications précédentes, dans lequel le dispositif multicouche M et/ou le dispositif multicouche M' ont une épaisseur inférieure à 50 nm, notamment inférieure à ou égale à 15 nm, en particulier inférieure à ou égale à 10 ou 6 nm.

7. Procédé selon l'une quelconque des revendications précédentes, dans lequel la gravure sélective de l'étape (v) est une gravure humide ou sèche, notamment une gravure (ALE), par exemple par plasma (anisotrope), ou thermique (isotrope).

8. Procédé selon l'une quelconque des revendications précédentes, dans lequel :
- La couche A du dispositif M' est à dominante amorphe ;
- La couche A du dispositif M est à dominante orthorhombique ;
- La couche B du dispositif M' est à dominante tétragonale ;
- La couche B du dispositif M est à dominante tétragonale.

9. Procédé selon l'une quelconque des revendications précédentes, dans lequel le recuit de l'étape (iii) est réalisé à une température de 300 à 600 °C, notamment de 300 à 500°C, en particulier à 400°C environ.

10. Procédé selon l'une quelconque des revendications précédentes, dans lequel l'électrode métallique mentionnée relativement à l'étape (ii) et/ou l'électrode métallique mentionnée relativement à l'étape (vi) sont déposées par dépôt physique en phase vapeur (PVD) ou dépôt chimique en phase vapeur (CVD).

11. Procédé selon l'une quelconque des revendications précédentes, dans lequel l'électrode métallique mentionnée relativement à l'étape (i), l'électrode métallique mentionnée relativement à l'étape (ii) et/ou l'électrode métallique mentionnée relativement à l'étape (vi) sont constituées de ou comprennent un métal notamment choisi parmi titane, or, aluminium platine, ruthénium, molybdène, cuivre, et tungstène, un matériau comprenant ledit métal, notamment un nitrure métallique, par exemple TiN, WN, TaN, ou MoN, ou leurs mélanges.

12. Procédé selon l'une quelconque des revendications précédentes, dans lequel l'électrode métallique mentionnée relativement à l'étape (i), l'électrode métallique mentionnée relativement à l'étape (ii) et/ou l'électrode métallique mentionnée relativement à l'étape (vi) ont une épaisseur comprise de 2 ou 5 à 500nm, particulièrement de 10 à 100nm.
